# EUROPEAN PATENT APPLICATION

(11) **EP 4 847 973 A1**
(43) Date of publication of application: **02.12.2026**
(21) Application number: 25178790.9
(22) Date of filing: 26.05.2025
(51) Int. Cl.: G02B 5/08, G03F 1/24, G03F 7/00, G21K 1/06

(54) **METHOD FOR CREATING A REFLECTIVE ELEMENT COMPRISING A DIFFUSER, REFLECTIVE ELEMENT, AND A LITHOGRAPHIC APPARATUS INCLUDING THE REFLECTIVE ELEMENT**

(71) Applicant: ASML Netherlands B.V., 5500 AH Veldhoven (NL)
(72) Inventor: CHONG, Derick, Yun, Chek, 5500 AH Veldhoven (NL); GUI, Li, 5500 AH Veldhoven (NL); GEELEN, Paul, Jean, Maurice, 5500 AH Veldhoven (NL); DIKKERS, Manfred, Petrus, Johannes, Maria, 5500 AH Veldhoven (NL)
(74) Representative: ASML Netherlands B.V.

(57) **Abstract**

The disclosure provides a method of manufacturing a reflective element comprising a diffuser, the method comprising: providing a base layer; providing the base layer with a pseudo-random patterned layer; and providing a reflective multilayer on the patterned layer. The patterned layer has a thickness of about 1/4 lambda of an intended irradiation. The patterned layer may be arranged in a base layer; on the base layer; or in between the reflective multilayer and a second reflective multilayer deposited on the base layer.

## Description

### FIELD

The present disclosure relates to a method to create a reflective element comprising a diffuser, and to a reflective element comprising a diffuser. The disclosure also relates to a lithographic apparatus including the reflective element. The reflective element may be a reflective optical element suitable for reflecting extreme ultraviolet light (EUV). The element may be included in a marker or grating applied on a reticle, a reticle blank, or a fiducial.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Projection optics of the lithographic apparatus typically comprise a significant number of optical elements to project the radiation, provided with a certain pattern, onto a substrate. Due to the aspired nanometer sized patterns which have to be projected onto the substrate, even small aberrations in the projection optics may limit the accuracy of the projection. Aberration measurements of the projection optics in the lithographic apparatus may therefore be included, which may allow to adjust the pattern of the radiation to correct for the aberrations in the optics.

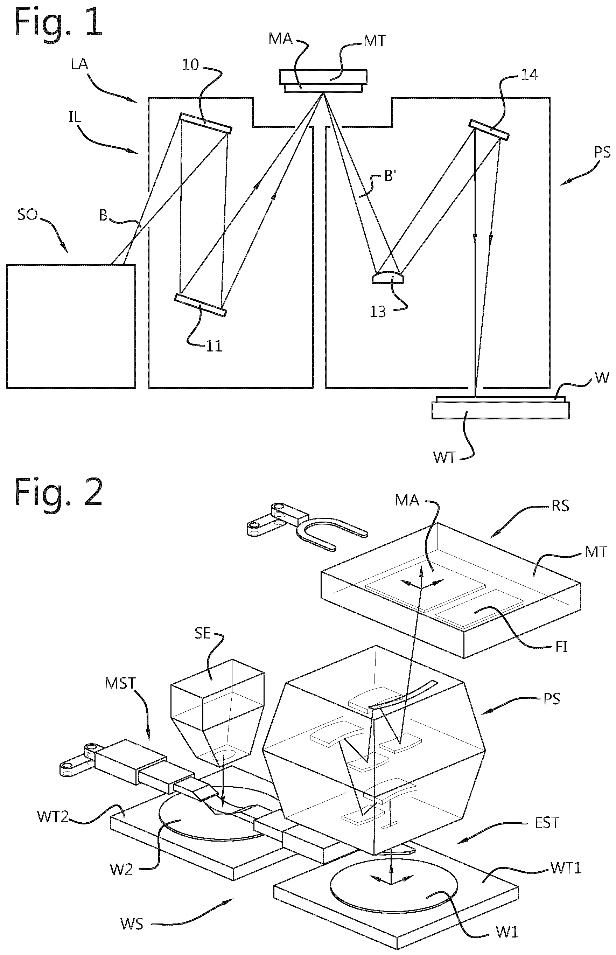

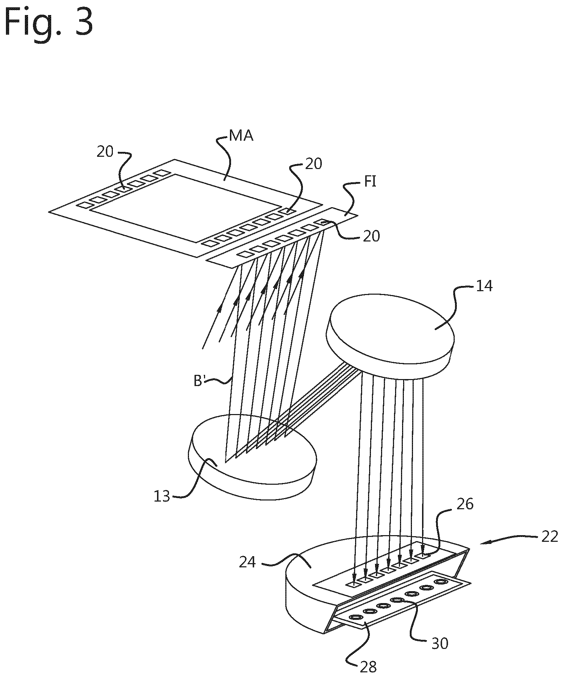

Aberration measurements may involve image sensors such as an alignment sensor or an image sensor. The latter may be referred to as a shearing wavefront interferometer. Examples of such sensors are the ILIAS (Integrated lens interferometry at Scanner ) sensor or PARIS (Parallel ILIAS) sensor. Generally referring to Figure 2 and 3, such sensors typically use one or more gratings at reticle level and corresponding grating(s) at wafer level. For accurate measurements, these sensors typically require a full and evenly filled lens pupil to accurately determine any potential optical aberrations. During the measurement however, the lithographic apparatus may use illumination settings (such as dipole illumination) which do not fill the pupil completely.

Conventionally, an evenly filled pupil can be obtained by the application of a diffuser applied onto optical elements. The diffuser can diffuse incident radiation as reflected by the grating at reticle level.

An example of such a diffuser is the application of a chromium (Cr) layer underneath the Molybdenum-Silicon (MoSi) reflective multilayer of the reticle.

Another technique involves the application of a relatively rough quarts coated with a MoSi multilayer for reflecting and scattering the light. The scattered light then illuminates the source grating which stands on a thin membrane that is supported by the quartz substrate.

Both existing technologies require complex fabrication steps that are prone to high defectivity. This limits the adaptation of these technologies in high throughput production processes.

For instance, a chromium based diffuser layer is relatively difficult to reproduce consistently. Application of the chromium layer typically involves a process such as sputtering, which is relatively inaccurate. The latter means that different reticles or fiducials may be provided with different diffuser layers. This in turn results in significant variations between respective reticles or fiducials provided with such a diffuser. Due to the inconsistencies and tolerance variations between respective diffuser layers, the application of the rough chromium diffuser layer is not possible or acceptable for reticles intended for production processes. Due to variations in manufacturing, the diffuser layer cannot be applied in the exact same way for each fiducial. As the fiducial serves as a reference for sensors, said sensors may suffer from a measurement accuracy impact due to variations between respective fiducials in different lithographic apparatus. I.e., the fiducial for each lithographic apparatus may be slightly different, requiring dedicated tuning for each machine. For example, the negative impact on sensor accuracy due to these variations between respective diffusers in different lithographic apparatuses may be on the order of 20 pm.

A disadvantage of the rough in-plane diffusers as conventionally used for fiducials in EUV relates to variations in manufacturing. As a result, the diffuser cannot be applied in the exact same way for each fiducial. Consequently, the sensors used for aberration measurements suffer from a measurement accuracy impact due to said variations between respective diffuser layers.

WO2021069231A1 discloses a diffuser configured to receive and transmit radiation, wherein the diffuser comprises: a scattering layer configured to scatter the received radiation, the scattering layer comprising a first substance and having distributed therein a plurality of voids, wherein either: the first substance is a scattering substance, or at least one of the voids contains a scattering substance and the first substance has a lower refractive index than the scattering substance. The scattering substance comprises a body of contacting particles and the voids are provided between adjacent particles. The particles comprise a binary mixture comprising a first material and a second material with a refractive index different to the first material.

US20210382209A1 discloses a diffusor configured to receive and transmit radiation, the diffusor comprising a plurality of layers, each layer arranged to change an angular distribution of radiation passing through it differently than another layer of the plurality of layers. At least one of the plurality of layers may comprise a layer of scattering material with a nanostructure provided on at least one surface thereof. The layer of scattering material may be adjacent a layer of support material, the support material having a nanostructure on at least one surface thereof.

EP3640734A1 discloses a diffusor configured to receive and transmit radiation, wherein the diffusor comprises: a plurality of layers, each layer arranged to change an angular distribution of radiation passing through it differently. At least one of the plurality of layers may comprise a layer of scattering material with a nanostructure provided on at least one surface thereof. The scattering material may comprise one of the following: molybdenum, ruthenium, niobium, rhodium or technetium.

US20040136075A1 discloses an electromagnetic radiation diffuser comprising: a substrate having a first and a second surface, said first surface having a structure with a three dimensional profile of individual grid units; a reflective coating formed on said first surface, wherein said reflective coating conforms to said structure. Herein, said individual grid units may have randomly selected heights over a predetermined range.

### SUMMARY

The present disclosure aims to provide a more accurate system and method to diffuse EUV radiation.

The disclosure provides a method of manufacturing a reflective element comprising a diffuser, the method comprising:
providing a base layer;
providing the base layer with a pseudo-random patterned layer; and
providing a reflective multilayer on the patterned layer.

In an embodiment, the patterned layer has a thickness of about 1/4 lambda of an intended irradiation. Herein, 1/4 lambda may be on the order of 3 to 5 nm.

In an embodiment, the step of arranging the pseudo-random patterned layer comprises one of:
- arranging the patterned layer in the base layer;
- arranging the patterned layer on the base layer; or
- arranging the patterned layer in between the reflective multilayer and a second reflective multilayer deposited on the base layer.

In an embodiment, the reflective multilayer is adapted for reflecting EUV radiation and is comprised of multiple layers comprising molybdenum and silicon (MoSi) respectively.

According to another aspect, the disclosure provides a reflective element, comprising at least one diffuser, the diffuser comprising:
a pseudo-random patterned layer; and
a reflective multilayer provided on the patterned layer.

In an embodiment, the patterned layer has a thickness of about 1/4 lambda of intended irradiation. Herein, 1/4 lambda may be on the order of 3 to 5 nm.

In an embodiment, the pseudo-random patterned layer is arranged:
- in a base layer of the reflective element;
- on a base layer of the reflective element; or
- in between the reflective multilayer and a second reflective multilayer deposited on a base layer of the reflective element.

In an embodiment, the reflective multilayer is adapted for reflecting EUV radiation and is comprised of multiple layers comprising molybdenum and silicon (MoSi) respectively.

In an embodiment, the reflective element comprises a second patterned layer provided on the reflective multilayer.

According to another aspect, the disclosure provides a reticle, reticle blank, or fiducial including at least one reflective element comprising a diffuser, the diffuser comprising a pseudo-random patterned layer and a reflective multilayer provided on the patterned layer.

In an embodiment, the at least one reflective element comprises a second patterned layer provided on the reflective multilayer, the second patterned layer providing a marker pattern.

According to another aspect, the disclosure provides a lithographic apparatus comprising:
an illumination system configured to condition a radiation beam;
a support structure constructed to support a patterning device, the patterning device being capable of imparting the radiation beam with a pattern in its cross-section to form a patterned radiation beam;
a substrate table constructed to hold a substrate; and
a projection system configured to project the patterned radiation beam onto the substrate,
wherein the support structure is provided with a reflective element comprising at least one diffuser, the diffuser comprising:
   a pseudo-random patterned layer; and
   a reflective multilayer provided on the patterned layer.

In an embodiment, the illumination system comprises a source of extreme ultraviolet light (EUV).

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a perspective view of an exemplary substrate stage and projection system of a lithographic apparatus;
- Figure 3 depicts a perspective view of an exemplary sensor system for the projection system;
- Figures 4A to 4C depict a cross section of respective embodiments of a reflective element including a diffuser according to the present disclosure;
- Figure 5 depicts respective steps of a method to fabricate an element according to the present disclosure;
- Figure 6A depicts a top view of an embodiment of a patterned layer according to the present disclosure;
- Figure 6B depicts an example of a pupil of reflected radiation when using a reflective element comprising the patterned layer of Fig. 6A;
- Figure 7A depicts a top view of another embodiment of a patterned layer according to the present disclosure; and
- Figure 7B depicts an example of a pupil of reflected radiation when using a reflective element comprising the patterned layer of Fig. 7A.

### DETAILED DESCRIPTION

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

Figure 2 shows a reticle stage RS for supporting a patterning device MA such as a reticle. The reticle is located in an object plane. A wafer stage WS may comprise two substrate stages WT1, WT2 which can function in parallel. Each substrate table may be movable, and can support a respective substrate W1, W2 in an image plane. Projection optics of the projection system PS are arranged to form an image of the object in the object plane in the image plane. The object and image planes are conjugate and may be referred to as field planes.

The substrate stage may be provided with a measurement station MST, also referred to as measurement side of the substrate stage. The measurement station may comprise sensing equipment SE for measuring certain qualities of a respective substrate W2 arranged on the corresponding substrate table WT2. The substrate stage is typically also provided with an expose station EST for projecting an image onto a respective substrate using projection optics of the projection system PS. The expose station may also be referred to as the expose side of the substrate stage. The substrate tables can move with respect to each other and with respect to the measurement station and the expose station, enabling to measure and pre-condition one substrate, while another substrate is being irradiated at the expose station.

The radiation beam B may be patterned by an object in the object plane. Said object may be a reticle MA or a fiducial FI. The fiducial may be regarded as a standardized reticle, which may be built into the lithographic apparatus and can be used as a reference. The reticle itself can be replaced, allowing to provide a pattern of choice to the beam of radiation.

Reticles and/or fiducials may be provided with a pellicle. The pellicle is a thin EUV transmissive membrane spaced apart from the object plane or reticle level so as to exclude contaminants. Pellicles may be comprised of a carbon nanotube-based composition.

Referring to Figure 3, the reticle MA and fiducial FI may be provided with one or more first marks 20, also referred to as reticle level marks. Said first marks may assist, for instance, reticle alignment.

The lithographic apparatus may comprise one or more sensors 22. For example, the sensors may include one or more transmission image sensors (TIS) or interferometric sensors for detecting reticle alignment (with the aid of the reticle level marks 20) and projection optics aberrations respectively. The latter may be referred to as Integrated Lens Interferometry At Scanner (ILIAS) sensor. Multiple ILIAS sensors can be used in parallel, which may be referred to as a parallel ILIAS sensor or PARIS sensor.

As exemplified in Figure 3, a sensor 22 may comprise a sensor die 24, one or more second marks 26, and/or one or more detectors 28 for detecting transmission 30 of radiation through the second marks 26. The one or more second marks 26 may also be referred to as sensor level marks or wafer stage marks.

In order to achieve optimal performance of some or all of the sensors 22, a fully filled pupil of the projection optics is desirable. Pupil herein refers to a range of angles at which the beam B' of radiation can be directed onto the wafer stage, and thus onto the respective sensor 22. For EUV radiation, not all angles within said range have the same intensity. Fully filling the pupil of the projection optics may be achieved by using a diffuser located at the reticle level.

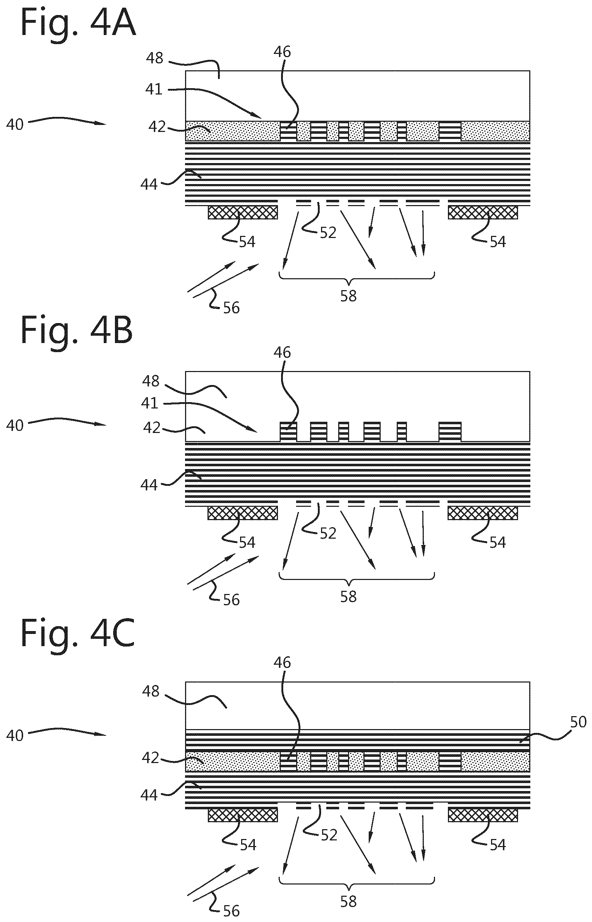

Generally referring to Figures 4A to 4C, embodiments of a reflective element 40 may comprise at least one diffuser 41. According to the present disclosure, the diffuser may comprise a pseudo-random patterned layer 42. A reflective multilayer 44 may be provided on the patterned layer 42. The first patterned layer 42 is provided with a first pattern 46. A second patterned layer 54 may be arranged on the reflective multilayer 44. The second patterned layer may have a second pattern. The second pattern may include a line pattern or a 2-dimensional pattern such as a checkerboard pattern or a Gingham pattern or a 2-dimensional grid of circular openings. The second patterned layer 54 and its second pattern may function as a grating. The reflective element 40 thus may be used as a reflective marker.

The first pattern 46 can influence incoming, non-diffuse EUV radiation 54 and cause the reflected EUV radiation 58 to be diffuse. The second pattern instead imparts its pattern on the reflected radiation 58. More detail thereof is provided below.

As exemplified in Figure 4A, the pseudo-random patterned layer 42 can be arranged on a base layer 48 of the reflective element.

As exemplified in Figure 4B, the pseudo-random patterned layer 42 can be arranged in the base layer 48. Herein, the pattern 46 of the patterned layer 42 may be created in the material of the base layer. For instance, the pattern may be etched into the base layer 48.

As exemplified in Figure 4C, the pseudo-random patterned layer 42 can be arranged in between the reflective multilayer 44 and a second reflective multilayer 50. The second reflective multilayer 50 may be deposited on the base layer 48 of the reflective element.

The embodiments described above may be used as reflective markers. Said markers are suitable to, for instance, perform aberration measurements or alignment measurements. The patterned absorber layer 54 herein may provide a certain marker pattern. For measurements, the reflected radiation 58 may typically need to have a pattern, such as a line pattern of light and dark. The latter pattern is typically made using the second patterned layer 54. The second patterned layer is typically comprised of an absorber material. Said material may absorb part of the incoming EUV radiation 56, corresponding to the second pattern of the second patterned layer 54. The second pattern may be a grating, i.e. a line pattern with line shaped openings. In conjunction, the layers of the reflective element 40 may provide the function of a marker. Herein, the first pattern 46 of the first patterned layer 42 serves to diffuse the reflection 58. The first pattern 46 does not cause a pattern (such as a line pattern) in the reflected beam 58, but rather ensures that the reflected radiation 58 is diffuse and fills all angles of the pupil. The second patterned layer 54 has a second pattern. The second patterned layer 54 does impart a pattern on the reflected radiation 58. Said second pattern is predetermined depending on the respective marker or grating. The marker may be used for measurements, as explained herein above.

In a practical embodiment, the patterned layer 42 has a thickness of about 1/4 lambda of the irradiation 56. Herein, 1/4 lambda is on the order of 3 to 5 nm.

The reflective multilayers 44, 50 are typically adapted for reflecting EUV radiation. Herein, the multilayers may be comprised of multiple layers comprising molybdenum and silicon (MoSi) respectively.

EUV light (with a wavelength λ of about 13.5 nm) is absorbed by all known materials; therefore, one cannot simply make a transmissive mask as is commonly used in optical lithography employing longer wavelengths. It is, however, possible to build Bragg mirrors for EUV light by using Molybdenum/Silicon (MoSi) bilayers of 3nm and 4nm thickness, respectively. The process then becomes one of reflectance rather than transmittance.

MoSi multilayers are now commonly used in EUV optic systems. These multilayers are used for optical elements such as mirrors, but also for masks, also referred to as reticle when the reflective kind is meant. Reticles are typically patterned versions of an unpatterned base mask, which typically is referred to as a mask blank or reticle blank.

Mask blanks or reticle blanks are typically made of 6-inch square, low thermal expansion material glass substrates for the base layer 48. The base layer is typically coated with MoSi multilayers and surmounted with a capping layer.

Typically, 40 to 50 bilayers are required to achieve a reflectivity of about 62 to 70% at a wavelength λ of the EUV radiation of about 13.5nm. The reticle blanks may be coated with a 70 nm tantalum nitride-based layer that will be patterned to form the absorbing masks, or the second patterned layer 54.

One or more reflective elements as disclosed herein may be provided on a reticle, a reticle blank or a fiducial. The reflective elements may be intended or adapted for measurements such as wavefront measurements or image alignment.

The system and method of the present disclosure provide a concept of diffusing light or other radiation based on an embedded digitally attenuated phase diffuser. The method and system comprise a patterned layer provided with a pseudo-random pattern.

The pattern of the first patterned layer may be etched onto the base layer below the MoSi multilayer. The patterned layer may have a thickness of about a quarter lambda, or 1/4 of the wavelength λ of the radiation 56. For application with EUV in a lithographic process, the latter may, in practice, be about 3.4 nm to 5 nm. The multilayer is then expected to roughly follow the step height of 1/4 of the wavelength, i.e. 1/4 times λ. See the outer surface 52 of the multilayer, in Figures 4A to 4C.

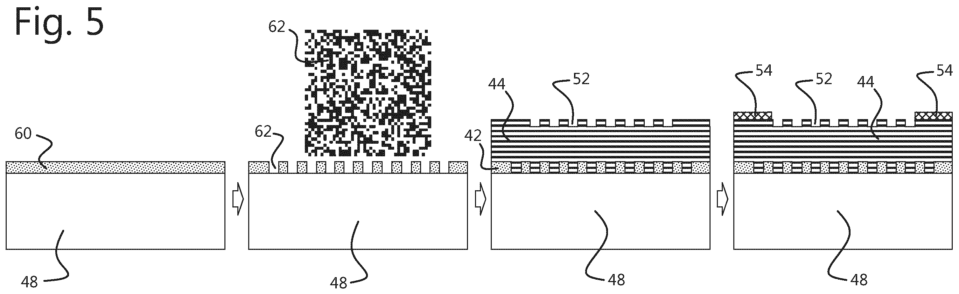

Generally referring to Figure 5, a method to fabricate a system of the present disclosure may include the following steps. First, see the diagram on the left in Fig. 5, a base layer 48 can be provided with a cover layer 60. The cover layer may be comprised of a material suitable for lithographic processing. Said material may depend on the next step of providing a pattern. Said material may, for instance, include a photo resist. Alternatively, the layer 60 is obviated, but instead represents a top layer of the base layer 48. The base layer may be comprised of a glass like material, such as quartz.

In a subsequent step, see the middle graphic in Fig. 5, a pattern 62 for diffusing EUV radiation may be created in the cover layer 60. The pattern 62, shown both in top view and side view in the graphic, may be created using one or more techniques such as, but not limited to: lithography on photoresist; ion beam deposition; chemical vapor deposition (CVD); physical deposition; etching.

Herein, please note that Figure 5 provides an example. As an alternative to providing a cover layer 60, the pattern 62 may be etched directly into the base layer 48 (See Fig. 4B). Herein, the base layer may be comprised of a glass like material.

Subsequently, the reflective multilayer 44 may be applied onto the patterned layer 42. As the multilayer 44 will follow the pattern included in the patterned layer 42, the exposed surface of the multilayer will be provided with a diffusive pattern 52 as well.

Next, a layer 54 of EUV absorbing material is applied onto the reflective multilayer. The layer 54 may be comprised of a material such as tantalum or tantalum oxide. A pattern is subsequently created in said layer, for instance by etching, to create openings for, for instance, gratings or other marker patterns.

The reproduction of the stepped pattern in the multilayer creates diffusive patterns that enable scattering properties. The latter follows the pattern of the patterned layer, which in turn can be tuned. Said tuning may be based on, for instance, homogeneity or spatial distribution of scattered radiation, integrated intensity within the available numerical aperture (NA).

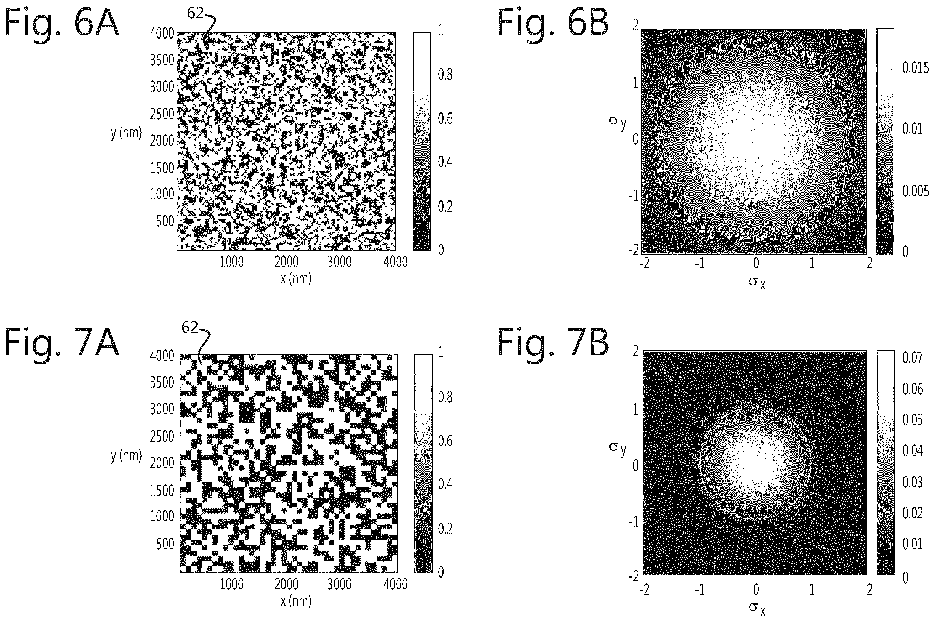

As an example, two types of patterns 62 are proposed:
a. QR pattern: the feature size L of the QR pattern can be tuned to achieve the desired scattering properties (e.g. Gaussian profiles), see Figure 6A and Figure 7A.
b. Random Squares or shapes: A random squares method can create a more controlled distribution of different squares and feature sizes to achieve more specific scattering performance. For instance, this method may achieve non-Gaussian profiles, or top-hat profiles.

The method of the present disclosure can be applied to optimize scattering for different illumination pupil settings.

In selecting or designing the base material layer, the following aspects may be considered:
a. The base layer 48 and the first patterned layer 42 may be made of a material that can be etched and processed within industry standards.
b. The thickness and fill ratio (clear/absorber surface area) of the first patterned layer 42 may be tuned to create destructive interference for the 0th order, and therefore suppress the specular component (0th order).
c. An ideal fill ratio of the pupil may enable 50% of the area with 0 phase delay and 50% of the area with π phase delay.
d. An ideal thickness of the base layer may roughly correspond to a π shift delay.

The embedded patterned layer 42 as disclosed herein typically only attenuates the phase (and not the amplitude) of the incoming radiation. As a result, the diffused radiation 58 as reflected off of the element 40 including the embedded patterned layer 42 is less, or not, sensitive to various incoming illumination pupil shapes. This is a significant improvement with respect to conventional diffuser technologies, that typically do depend on the illumination pupil shape. This is because, unlike the pattern of the patterned layer 42, conventional diffuser technologies attenuate both the phase and amplitude of the incoming radiation.

Figure 6A exemplifies a pattern 62 of the embedded patterned layer 42 having a QR pattern with L=50nm. Upon illuminating with a fill ratio of about 50%, Figure 6B shows the resulting intensity spectrum of a normal incident ray.

Figure 7A exemplifies a pattern 62 of the embedded patterned layer 42 having a QR pattern with L=100nm. Upon illuminating with a fill ratio of about 50%, Figure 7B shows the resulting intensity spectrum of a normal incident ray.

Figures 6A to 7B indicate that the intensity spectrum can be tunes based on the pitch L of the pattern 62.

The system and method of the disclosure can be more easily adopted by conventional production processes typically available at production locations for semiconductor processing. The patterned layer 42 can be created using controllable processes, allowing tighter tolerances and improved reproducibility with smaller tolerance levels, compared to the sputtering technique as typically used for deposition of a chromium based diffuser.

The invention can enable reticle alignment (RA), e.g. using a shearing wavefront interferometer such as the PARIS sensor, on an EUV scanner. In other words, a single sensor system can be used to measure both wavefront aberrations and image alignment, thereby obviating the separate step for image alignment in the production process. The latter will result in a large improvement for scanner system performance, most significantly by speeding to production and thereby increasing productivity and throughput. Depending on machine configuration, the gain in throughput may be on the order of three to nine wafers per hour.

The diffuser system and method of the present disclosure can also be applied to markers on the fiducial. For ILIAS sensor accuracy, the present disclosure can improve performance because the layer underneath the multilayer may now be created using a lithographic processing step instead of sputtering Cr. This will create relatively repeatable diffuser properties, thus limiting differences between fiducials applied in different lithographic apparatuses.

Because the diffuser will be repeatable, this also opens possibilities to make a final correction on the remaining error via extensive offline calculations. The latter results can be then be applied to all EUV systems, since they will all be equipped with substantially similar fiducials. The system and method of the present disclosure are expected to bring down the accuracy error from 20 pm to below 5 pm.

The system and method according to the present disclosure provide a relatively simple, effective and reproducible means to diffuse and reflect EUV radiation. The system and method enable to fill the entire pupil, or range of angles of reflection. The latter enables to use respective sensors for high accuracy wavefront measurements, involving a large array of higher order aberrations (Z² to Z¹⁰⁰).

The diffuse reflection of EUV light provided by the method and system of the present disclosure provide an additional advantage. The system and method of the disclosure can be used to create a mark or marker on a reflective item at the reticle stage level. Said item may be a fiducial, a reticle, or a reticle blank. As described above, the creation of a mark or marker on the reticle blank or fiducial may involve applying a pattern of an absorber layer 54 to selectively absorb portions of the received radiation 56. The portions of the reflective element 40 without absorber 54 would then reflect radiation 58 in a diffused manner.

As the diffuse reflection of EUV light includes not only higher order output, but also lower order, the latter enables to use the same mark(er) for aberration measurements using a shearing wavefront interferometer, e.g. ILIAS / PARIS and also for image alignment. The latter enables to do both measurements in the same step, or at least, in the same process sequence. This ultimately may mean a faster process, as the separate step of image align measurement and alignment can be obviated, as it can be included in the step of wavefront measurement (optical system aberration measurement). In a lithographic process, every millisecond of throughput improvement is relatively worthwhile, meaning that obviating an entire measurement step is relatively valuable.

Although specific reference may be made in this text to the use of lithographic apparatus in the manufacture of integrated circuits or other semiconductor related processing, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of manufacturing a reflective element comprising a diffuser, the method comprising:
providing a base layer;
providing the base layer with a pseudo-random patterned layer; and
providing a reflective multilayer on the patterned layer.

2. The method according to claim 1, wherein the patterned layer has a thickness of about 1/4 lambda of an intended irradiation.

3. The method of claim 2, wherein 1/4 lambda is on the order of 3 to 5 nm.

4. The method of one of the previous claims, wherein the step of arranging the pseudo-random patterned layer comprises one of:
- arranging the patterned layer in the base layer;
- arranging the patterned layer on the base layer; or
- arranging the patterned layer in between the reflective multilayer and a second reflective multilayer deposited on the base layer.

5. The method of one of the previous claims, wherein the reflective multilayer is adapted for reflecting EUV radiation and is comprised of multiple layers comprising molybdenum and silicon (MoSi) respectively.

6. A reflective element, comprising at least one diffuser, the diffuser comprising:
a pseudo-random patterned layer; and
a reflective multilayer provided on the patterned layer.

7. The reflective element of claim 6, wherein the patterned layer has a thickness of about 1/4 lambda of intended irradiation.

8. The reflective element of claim 7, wherein 1/4 lambda is on the order of 3 to 5 nm.

9. The reflective element of one of claims 5 to 8, wherein the pseudo-random patterned layer is arranged:
- in a base layer of the reflective element;
- on a base layer of the reflective element; or
- in between the reflective multilayer and a second reflective multilayer deposited on a base layer of the reflective element.

10. The reflective element of one of claims 6 to 9, wherein the reflective multilayer is adapted for reflecting EUV radiation and is comprised of multiple layers comprising molybdenum and silicon (MoSi) respectively.

11. The reflective element of one of claims 6 to 10, comprising a second patterned layer provided on the reflective multilayer.

12. Reticle, reticle blank, or fiducial including at least one reflective element comprising a diffuser, the diffuser comprising a pseudo-random patterned layer and a reflective multilayer provided on the patterned layer.

13. The reticle, reticle blank, or fiducial according to claim 12, wherein the at least one reflective element comprises a second patterned layer provided on the reflective multilayer, the second patterned layer providing a marker pattern.

14. A lithographic apparatus comprising:
an illumination system configured to condition a radiation beam;
a support structure constructed to support a patterning device, the patterning device being capable of imparting the radiation beam with a pattern in its cross-section to form a patterned radiation beam;
a substrate table constructed to hold a substrate; and
a projection system configured to project the patterned radiation beam onto the substrate,
wherein the support structure is provided with a reflective element comprising at least one diffuser, the diffuser comprising:
a pseudo-random patterned layer; and
a reflective multilayer provided on the patterned layer.

15. The lithographic apparatus of claim 14, wherein the illumination system comprises a source of extreme ultraviolet light (EUV).
